# DEMANDE DE BREVET EUROPEEN

(11) **EP 0 903 848 A1**
(43) Date de publication de la demande: **24.03.1999**
(21) Numéro de dépôt: 98203088.4
(22) Date de dépôt: 16.09.1998
(51) Int. Cl.: H03F 3/45, H03F 3/343

(54) **Dispositif de conversion d'un signal symétrique en un signal asymétrique**

(30) Priorité: 23.09.1997 FR 9711831
(71) Demandeur: Koninklijke Philips Electronics N.V., 5621 BA Eindhoven (NL)
(72) Inventeur: Greer, Nigel, Société Civile S.P.I.D., 75008 Paris (FR)
(74) Mandataire: Caron, Jean

(57) **Abrégé**

La présente invention concerne un dispositif de conversion CONV, muni d'une tension d'entrée symétrique Vin en une tension de sortie asymétrique Vout, comprenant :
. un module transconductance TCM destiné à délivrer un courant itcm dont la valeur est liée à celle de la tension d'entrée Vin, et
. un module résistif RM destiné à transformer le courant itcm en une tension Vout référencée par rapport à un potentiel prédéterminé.

Selon l'invention, le module transconductance TCM comporte une paire différentielle (Q1, Q2), recevant la tension d'entrée Vin, et des moyens de soustraction SUB destinés à recevoir les courants de collecteur issus de la paire différentielle (Q1, Q2), et à délivrer un courant itcm représentatif de la différence entre lesdits courants.
Applications : interface de circuits intégrés avec un circuit imprimé au sein d'appareils de radio-téléphonie.

## Description

La présente invention concerne un dispositif de conversion, muni d'une entrée symétrique destinée à recevoir une tension d'entrée et d'une sortie asymétrique destinée à délivrer une tension de sortie, comprenant :
. un module dit transconductance muni d'une entrée symétrique formant l'entrée du dispositif et d'une sortie destinée à délivrer un courant dont la valeur est liée à celle de la tension d'entrée, et
. un module dit résistif destiné à transformer le courant de sortie du module transconductance en une tension référencée par rapport à un potentiel prédéterminé.

De tels dispositifs de conversion sont couramment mis en oeuvre dans des appareils qui comportent plusieurs circuits intégrés alimentés sous une tension dite d'alimentation référencée par rapport à une masse commune, et qui sont reliés entre eux au moyen d'un circuit imprimé, comme par exemple des appareils de radio-téléphonie. En effet, il est préférable de gérer des signaux de tension de nature symétrique à l'intérieur de certains circuits intégrés, notamment pour des raisons de limitation de bruit, rendue possible grâce à la symétrie des structures qui découlent de la symétrie des signaux. Ces signaux symétriques sont de préférence référencés par rapport à la tension d'alimentation, souvent fournie par une batterie et donc sujette à variations. Les signaux transitant entre deux circuits intégrés via le circuit imprimé doivent, eux, être de nature asymétrique et référencés par rapport à la masse commune à l'ensemble des circuits.

Les dispositifs de conversion connus sont, pour la plupart, constitués par des montages à base d'amplificateurs opérationnels. Ainsi, un dispositif de conversion classique met en oeuvre un amplificateur opérationnel monté en amplificateur différentiel permettant d'élaborer une tension de nature asymétrique représentative de la tension symétrique d'entrée, suivi d'un amplificateur opérationnel commandant la conduction d'un courant, proportionnel à la tension de sortie de l'amplificateur différentiel, au travers d'une résistance connectée à la masse du circuit. De tels montages sont décrits dans l'ouvrage "The Art of Electronics" de Mm. Paul Horowitz et Winfield Hill. Le dispositif de conversion tel que décrit ci-dessus présente des inconvénients majeurs : chaque amplificateur opérationnel est en lui-même un circuit complexe, regroupant jusqu'à plusieurs dizaines de transistors. L'implémentation d'un tel dispositif nécessite donc l'utilisation d'une grande surface de silicium, ce qui le rend coûteux. De plus, lorsqu'ils sont soumis à des variations de leur tension d'alimentation, les amplificateurs opérationnels sont susceptibles d'introduire dans la tension de sortie une composante continue parasite qui peut nuire au bon fonctionnement de l'appareil.

L'invention a pour but de remédier dans une large mesure à ces inconvénients en proposant un dispositif de conversion possédant une structure plus simple, faisant appel à un nombre réduit de composants, tout en possédant une sensibilité atténuée aux variations de tension d'alimentation.

En effet, un dispositif de conversion conforme au paragraphe introductif est caractérisé selon la présente invention en ce que le module transconductance comporte :
. un premier et un deuxième transistor formant une paire différentielle, chacun muni d'une borne de référence, d'une borne de polarisation et d'une borne de transfert, les bornes de polarisation formant l'entrée symétrique du dispositif, et
. des moyens de soustraction munis de deux entrées destinées à recevoir des courants dits de transfert délivrés par les bornes de transfert des premier et deuxième transistors, et d'une sortie reliée à la sortie du module transconductance et destinée à délivrer un courant représentatif de la différence entre les courants de transfert.

Dans un tel dispositif de conversion, la paire différentielle transforme immédiatement la tension d'entrée en un courant différentiel sur lequel d'éventuelles variations de la tension d'alimentation ne peuvent avoir qu'une faible influence. D'autre part, le module transconductance selon l'invention ne comporte plus, au lieu des deux amplificateurs opérationnels décrits précédemment, qu'une simple paire différentielle et les moyens de soustraction.

Un mode de réalisation de l'invention présente un dispositif de conversion conforme à la revendication 2. Ce mode de réalisation des moyens de soustraction est avantageux par sa simplicité et permet une réalisation d'autant moins coûteuse du dispositif de conversion. Le module résistif peut, lui aussi, être réalisé sous une forme simple, conformément à la revendication 3.

Dans un mode de réalisation préféré de l'invention, les moyens pour placer la première borne de la résistance de sortie au potentiel prédéterminé sont conformes à la revendication 4.

La linéarité de la transformation de la tension d'entrée en un courant différentiel par la paire différentielle constituée par les premier et deuxième transistors peut être altérée lorsque l'amplitude de la tension d'entrée est suffisamment importante pour saturer lesdits transistors. Une variante de l'invention, conforme à la revendication 5, permet de corriger ce phénomène.

Ainsi qu'exposé précédemment, un dispositif de conversion selon l'invention est particulièrement bien adapté à une mise en oeuvre au sein d'un appareil de radio-téléphonie. L'invention concerne donc également un appareil de radio-téléphonie conforme à la revendication 6.

L'invention sera mieux comprise à l'aide de la description suivante de quelques modes de réalisation, faite à titre d'exemple non-limitatif et en regard des dessins annexés, dans lesquels :
- la figure 1 est un schéma fonctionnel décrivant un appareil de radio-téléphonie qui comporte un dispositif de conversion selon l'invention,
- la figure 2 est un schéma fonctionnel décrivant un dispositif de conversion selon l'invention, et
- la figure 3 est un schéma électrique décrivant un dispositif de conversion selon un mode de réalisation préféré de l'invention.

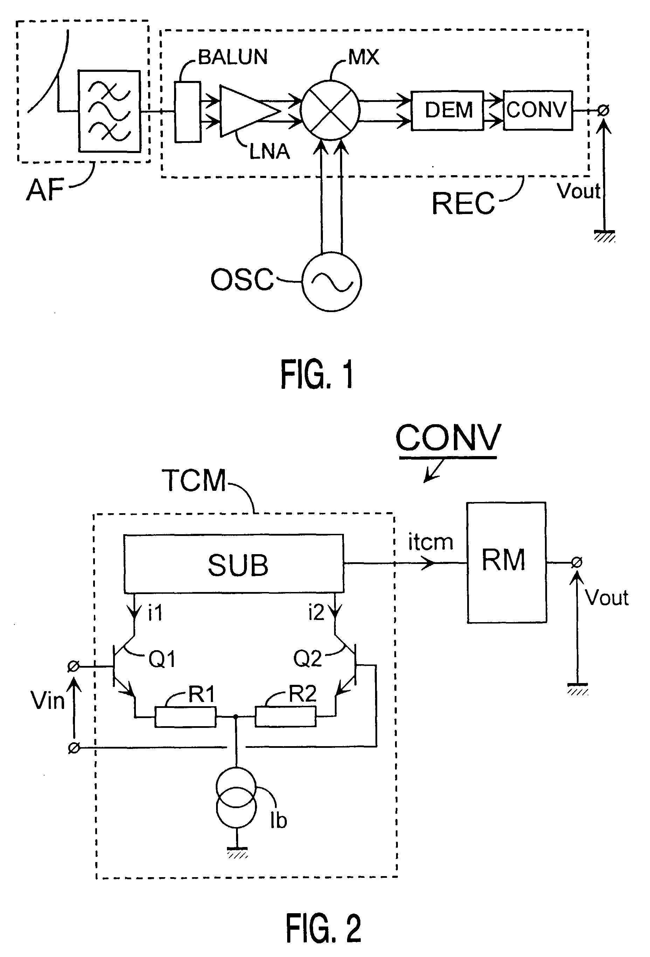

La figure 1 représente schématiquement un appareil de radio-téléphonie, qui comporte :
. un système d'antenne et de filtrage AF destiné à assurer la réception d'un signal radio-électrique et à délivrer sur une sortie un signal de tension asymétrique représentatif dudit signal,
. un circuit symétriseur BALUN muni d'une entrée reliée à la sortie du système d'antenne et de filtrage AF, et d'une sortie symétrique,
. un amplificateur LNA muni d'une sortie symétrique et d'une entrée symétrique reliée à la sortie du circuit symétriseur BALUN,
. un mélangeur MX muni d'une sortie symétrique, d'une première entrée symétrique reliée à la sortie de l'amplificateur LNA, et d'une deuxième entrée symétrique destinée à recevoir un signal de tension en provenance d'un oscillateur local OSC, et
. un démodulateur DEM muni d'une sortie symétrique et d'une entrée symétrique reliée à la sortie du mélangeur MX.

Le circuit symétriseur BALUN a pour fonction de transformer le signal délivré par le système d' antenne et de filtrage AF en un signal symétrique. Il assure également une adaptation d'impédance avec l'amplificateur LNA. Le circuit symétriseur BALUN, l'amplificateur LNA, le mélangeur MX et le démodulateur DEM sont de préférence réunis au sein d'un même circuit intégré REC, dit circuit récepteur. Du fait de la symétrie des signaux traités par les éléments précédemment décrits, les circuits sous la forme desquels ces éléments sont réalisés présentent une structure symétrique qui permet l'élimination par compensation d'un grand nombre de composantes de bruit inhérentes aux signaux traités. D'autre part, le circuit récepteur étant alimenté sous une tension dite d'alimentation référencée par rapport à une masse commune à tous les composants de l'appareil de radio-téléphonie, qui sont reliés entre eux au moyen d'un circuit imprimé, ces signaux sont référencés par rapport à la tension d'alimentation. Or les signaux transitant via le circuit imprimé doivent, eux, être de nature asymétrique et référencés par rapport à la masse commune à l'ensemble des circuits. L'appareil comporte donc un dispositif de conversion CONV, dont l'entrée symétrique est reliée à la sortie du démodulateur DEM et dont la sortie est destinée à délivrer une tension de sortie Vout démodulée de nature asymétrique et référencée par rapport à la masse.

La figure 2 représente schématiquement un tel dispositif de conversion CONV. Ce dispositif de conversion CONV est muni d'une entrée symétrique destinée à recevoir une tension d'entrée Vin et d'une sortie asymétrique destinée à délivrer une tension de sortie Vout. Il comprend :
. un module TCM dit transconductance muni d'une entrée symétrique formant l'entrée du dispositif et d'une sortie destinée à délivrer un courant itcm dont la valeur est liée à celle de la tension d'entrée Vin, et
. un module dit résistif RM destiné à transformer le courant de sortie itcm du module transconductance TCM en une tension Vout référencée par rapport à la masse.

Ce dispositif de conversion CONV est caractérisé en ce que le module transconductance TCM comporte :
. un premier et un deuxième transistor bipolaires, Q1 et Q2, formant une paire différentielle, chacun muni d'un émetteur constituant une borne dite de référence, d'une base constituant une borne dite de polarisation et d'un collecteur constituant une borne dite de transfert, les bases formant l'entrée symétrique du dispositif, et
. des moyens de soustraction SUB munis de deux entrées destinées à recevoir des courants dits de transfert, i1 et i2, délivrés par les collecteurs des premier et deuxième transistors, Q1 et Q2, et d'une sortie reliée à la sortie du module transconductance TCM et destinée à délivrer un courant itcm représentatif de la différence entre les courants de transfert i2 et i2. Le courant itcm, qui est égal à i1-i2, est proportionnel à la tension d'entrée Vin. Cette transformation tension-courant est, dans une large mesure, indépendante des variations de tension d'alimentation.

Des résistances de dégénérescence R1 et R2 rendent la transformation tension-courant linéaire lorsque les premier et deuxième transistors Q1 et Q2 fonctionnent hors de leur régime de saturation.

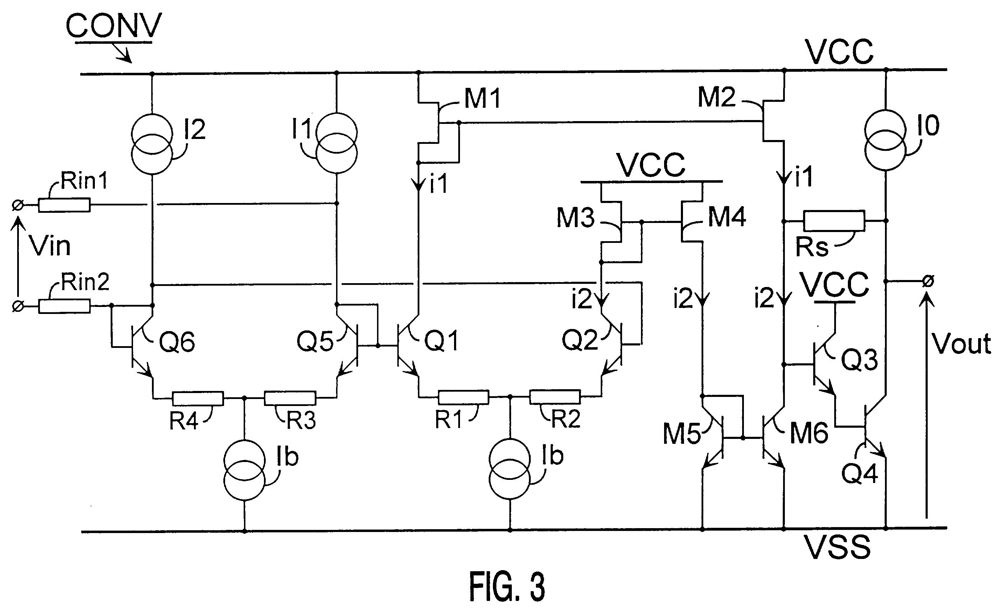

La figure 3 représente un mode de réalisation préféré de l'invention. Dans la mesure du possible, les références concernant des éléments déjà décrits plus haut ont été conservées afin de faciliter la compréhension de l'exposé. Dans ce mode de réalisation, les moyens de soustraction comportent :
. un premier et un deuxième miroir de courant, respectivement (M1, M2) et (M3, M4), munis chacun d'une branche d'entrée, d'une branche de sortie et d'une borne de référence reliée à une première borne d'alimentation VCC, les branches d'entrée des premier et deuxième miroirs de courant étant reliées aux bornes de transfert des premier et deuxième transistors Q1 et Q2, et
. un troisième miroir de courant (M5, M6), dont la borne de référence est reliée à une deuxième borne d'alimentation VSS constituant la masse du circuit, troisième miroir dont la branche d'entrée est reliée à la branche de sortie du deuxième miroir de courant, les branches de sortie des premier et troisième miroirs de courant (M1, M2) et (M5, M6) étant reliées ensemble à la sortie du module transconductance.

Le module résistif comporte :
. une résistance Rs dite de sortie dont une première borne est reliée à la sortie du module transconductance, c'est-à-dire aux branches de sortie des premier et troisième miroirs de courant (M1, M2) et (M5, M6) et dont une deuxième borne constitue la sortie du dispositif CONV, et
. des moyens pour placer la première borne de la résistance de sortie Rs à un potentiel prédéterminé.

Selon ce mode de réalisation de l'invention, le courant de transfert il parcourant le collecteur du premier transistor Q1 est reproduit sur la branche de sortie du premier miroir de courant (M1, M2), tandis que le courant de transfert i2 parcourant le collecteur du deuxième transistor Q2 est reproduit sur la branche de sortie du deuxième miroir de courant (M3, M4), puis sur la branche de sortie du troisième miroir de courant (M5, M6). La résistance de sortie Rs du module résistif est donc parcourue par un courant égal à i1-i2, et donc proportionnel à la tension d'entrée Vin, si l'on ignore l'étage d'entrée (Rin1, Rin2, I1, I2, Q5, Q6, R3, R4) dont l'utilité sera décrite dans la suite de l'exposé. Ainsi, le potentiel de la première borne de la résistance de sortie Rs étant fixé, il se produit dans ladite résistance Rs une chute de tension proportionnelle à la composante alternative de la tension Vin. La tension de sortie Vout qui en résulte est donc une tension de nature asymétrique, référencée par rapport au potentiel prédéterminé.

Les moyens pour placer la première borne de la résistance de sortie au potentiel prédéterminé comportent :
. une source de courant IO disposée entre la première borne d'alimentation VCC et la sortie du dispositif,
. un troisième transistor Q3, dont la base et le collecteur sont respectivement reliés à la première borne de la résistance de sortie Rs et à la première borne d'alimentation VCC, et
. un quatrième transistor Q4, dont la base est reliée à l'émetteur du troisième transistor Q3, dont l'émetteur est relié à la deuxième borne d'alimentation VSS, et dont le collecteur est relié à la sortie du dispositif.

Selon ce mode de réalisation, le potentiel de la première borne de la résistance de sortie Rs est égal à 2.Vbe+VSS, si Vbe représente une tension base-émetteur commune aux troisième et quatrième transistors Q3 et Q4. Ceux-ci étant polarisés au moyen de la source de courant IO débitant un courant de valeur fixe, leurs tensions base-émetteur sont également fixes, ce qui impose au potentiel de la première borne de la résistance de sortie Rs un potentiel fixe. La tension de sortie Vout est donc une tension de nature asymétrique, dont la composante alternative est proportionnelle aux variations de la tension d'entrée Vin et dont la composante continue est constamment égale 2.Vbe+VSS. La tension de sortie Vout est donc référencée par rapport à la masse.

Une bonne linéarité de la transformation tension-courant peut être obtenue, en l'absence de l'étage d'entrée (Rin1, Rin2, I1, I2, Q5, Q6, R3, R4), en choisissant pour les résistances de dégénérescence R1, R2 une valeur nominale de l'ordre de quelques dizaines de KiloOhms, mais ces résistances génèrerent alors d'importantes chutes de tension.

L'étage d'entrée (Rin1, Rin2, I1, I2, Q5, Q6, R3, R4) permet d'atténuer les effets néfastes que peuvent avoir de trop grandes amplitudes de variation de la tension d'entrée Vin sur la transformation tension-courant effectuée par le module transconductance. En effet, si la paire différentielle (Q1, Q2) reçoit directement une tension d'entrée Vin d'une amplitude suffisante pour saturer l'un des premier ou deuxième transistors Q1 ou Q2, les courants de transfert I1 et I2 seront tels que leur différence ne sera plus proportionnelle à la tension d'entrée Vin. C'est pourquoi le dispositif de conversion CONV comporte, dans ce mode de réalisation préféré de l'invention, insérée entre la paire différentielle formée par les premier et deuxième transistors, Q1 et Q2, et l'entrée symétrique du dispositif, une deuxième paire différentielle formée par un cinquième et un sixième transistor, Q5 et Q6, dont les bases sont respectivement reliées aux bases des premier et deuxième transistors, Q1 et Q2, dont les collecteurs sont reliés à la première borne d'alimentation VCC via des charges, chacun des cinquième et sixième transistors Q5 et Q6 ayant sa base reliée à son collecteur, ainsi qu'à une première borne d'une résistance dite d'entrée, Rin1 ou Rin2, les deuxièmes bornes desdites résistances d'entrée, Rin1 et Rin2, formant l'entrée symétrique du dispositif de conversion CONV.

Les chaînes d'éléments (Rin1, Q5, R3) et (Rin2, Q6, R4) forment un pont diviseur différentiel. La valeur de la tension qui parvient aux bases des premier et deuxième transistors, Q1 et Q2, n'est donc qu'une fraction de celle de la tension d'entrée Vin, ce qui limite les risques de saturation desdits transistors. En fixant les valeurs nominales des résistances d'entrée Rin1 et Rin2 à quelques dizaines de KiloOhms, des valeurs nominales de l'ordre du KiloOhm pour les résistances de dégénérescence R1, R2, R3 et R4 permettent d'obtenir une linéarité optimale sans pour autant créer de chutes de tension prohibitives.

Les charges des cinquième et sixième transistors, Q5 et Q6, sont ici des sources de courant, I1 et I2 Ceci permet d'assurer une polarisation desdits transistors indépendante de la tension d'entrée Vin et non des variations de ladite tension, ce qui ne serait pas le cas si les charges étaient des résistances.

Enfin, si les transistors Q1, Q2, Q3, Q4, Q5, Q6, M5 et M6 ont été représentés dans cet exemple sous la forme de transistors bipolaires, il sera bien évident pour l'homme du métier que des transistors de type MOS, dont les drains constitueraient les bornes de transfert, les sources les bornes de référence, et les grilles les bornes de polarisation, auraient pu leur être substitués. La réciproque est vraie pour les transistors M1, M2, M3 et M4.

## Revendications

1. Dispositif de conversion, muni d'une entrée symétrique destinée à recevoir une tension d'entrée et d'une sortie asymétrique destinée à délivrer une tension de sortie, comprenant :
. un module dit transconductance muni d'une entrée symétrique formant l'entrée du dispositif et d'une sortie destinée à délivrer un courant dont la valeur est liée à celle de la tension d'entrée, et
. un module dit résistif destiné à transformer le courant de sortie du module transconductance en une tension référencée par rapport à un potentiel prédéterminé,
dispositif caractérisé en ce que le module transconductance comporte :
. un premier et un deuxième transistor formant une paire différentielle, chacun muni d'une borne dite de référence, d'une borne dite de polarisation et d'une borne dite de transfert, les bornes de polarisation formant l'entrée symétrique du dispositif, et
. des moyens de soustraction munis de deux entrées destinées à recevoir des courants dits de transfert délivrés par les bornes de transfert des premier et deuxième transistors, et d'une sortie reliée à la sortie du module transconductance et destinée à délivrer un courant représentatif de la différence entre les courants de transfert.

2. Dispositif de conversion selon la revendication 1, caractérisé en ce que les moyens de soustraction comportent :
. un premier et un deuxième miroir de courant, munis chacun d'une branche d'entrée, d'une branche de sortie et d'une borne de référence reliée à une première borne d'alimentation, les branches d'entrée des premier et deuxième miroirs de courant étant reliées aux bornes de transfert des premier et deuxième transistors, et
. un troisième miroir de courant dont la borne de référence est reliée à une deuxième borne d'alimentation, dont la branche d'entrée est reliée à la branche de sortie du deuxième miroir de courant, les branches de sortie des premier et troisième miroirs de courant étant reliées ensemble à la sortie du module transconductance.

3. Dispositif de conversion selon la revendication 2, caractérisé en ce que le module résistif comporte :
. une résistance dite de sortie dont une première borne est reliée à la sortie du module transconductance et dont une deuxième borne constitue la sortie du dispositif, et
. des moyens pour placer la première borne de la résistance de sortie au potentiel prédéterminé.

4. Dispositif de conversion selon la revendication 3, caractérisé en ce que les moyens pour placer la première borne de la résistance de sortie au potentiel prédéterminé comportent :
. une source de courant disposée entre la première borne d'alimentation et la sortie du dispositif,
. un troisième transistor, dont les bornes de polarisation et de transfert sont respectivement reliées à la première borne de la résistance de sortie et à la première borne d'alimentation, et
. un quatrième transistor, dont la borne de polarisation est reliée à la borne de référence du troisième transistor, dont la borne de référence est reliée à la deuxième borne d'alimentation, et dont la borne de transfert est reliée à la sortie du dispositif.

5. Dispositif de conversion selon l'une quelconque des revendications 2 à 4, caractérisé en ce qu'il comporte, insérée entre la paire différentielle formée par les premier et deuxième transistors et l'entrée symétrique du dispositif, une deuxième paire différentielle formée par un cinquième et un sixième transistor, dont les bornes de polarisation sont respectivement reliées aux bornes de polarisation des premier et deuxième transistors, dont les bornes de transfert sont reliées à la première borne d'alimentation via des charges, chacun des cinquième et sixième transis tors ayant sa borne de polarisation reliée à sa borne de transfert, ainsi qu'à une première borne d'une résistance dite d'entrée, les deuxièmes bornes desdites résistances d'entrée formant l'entrée symétrique du dispositif.

6. Appareil de radio-téléphonie, comportant :
. un système d'antenne et de filtrage destiné à assurer la réception d'un signal radio-électrique et à délivrer sur une sortie un signal de tension asymétrique représentatif dudit signal,
. un circuit symétriseur muni d'une entrée reliée à la sortie du système d'antenne et de filtrage, et d'une sortie symétrique,
. un amplificateur muni d'une sortie symétrique et d'une entrée symétrique reliée à la sortie du circuit symétriseur,
. un mélangeur muni d'une sortie symétrique, d'une première entrée symétrique reliée à la sortie de l'amplificateur, et d'une deuxième entrée symétrique destinée à recevoir un signal de tension en provenance d'un oscillateur local, et
. un démodulateur muni d'une sortie symétrique et d'une entrée symétrique reliée à la sortie du mélangeur,
appareil caractérisé en ce qu'il comporte en outre un dispositif de conversion conforme à l'une quelconque des revendications 1 à 5, dont l'entrée symétrique est reliée à la sortie du démodulateur et dont la sortie est destinée à délivrer un signal de sortie démodulé de nature asymétrique.
